# EUROPEAN PATENT APPLICATION

(11) **EP 2 421 114 A1**
(43) Date of publication of application: **22.02.2012**
(21) Application number: 11166952.9
(22) Date of filing: 20.05.2011
(51) Int. Cl.: H02J 7/00, H01H 9/54, H01M 10/50

(54) **Battery heating circuit**

(30) Priority: 30.07.2010 CN 201010245288; 30.08.2010 CN 201010274785; 23.12.2010 CN 201010604729
(71) Applicant: Byd Company Limited, Shenzhen 518118 (CN)
(72) Inventor: Xu, Wenhui, 518118, Shenzhen (CN); Han, Yaochuan, 518118, Shenzhen (CN); Feng, Wei, 518118, Shenzhen (CN); Yang, Qinyao, 518118, Shenzhen (CN); Xia, Wenjin, 518118, Shenzhen (CN); Ma, Shibin, 518118, Shenzhen (CN)
(74) Representative: Kling, Simone

(57) **Abstract**

The present invention provides a battery heating circuit, comprising a switch unit (1), a switching control module (100), a damping element R1, an energy storage circuit, and an energy limiting circuit, wherein, the energy storage circuit is connected with the battery, and comprises a current storage element L1 and a charge storage element C1; the damping element R1, the switch unit (1), the current storage element L1, and the charge storage element C1 are connected in series; the switching control module (100) is connected with the switch unit (1), and is configured to control ON/OFF of the switch unit (1), so that the energy can flow to and fro between the battery and the energy storage circuit when the switch unit (1) switches on; the energy limiting circuit is configured to limit the magnitude of current flowing from the energy storage circuit to the battery. The battery heating circuit provided in the present invention can avoid the safety problem caused by overcurrent in the heating circuit, so as to protect the battery efficiently.

## Description

### Technical Field of the Invention

The present invention pertains to electric and electronic field, in particular to a battery heating circuit.

### Background of the Invention

In view cars have to run under complex road conditions and environmental conditions or some electronic devices are used under harsh environmental conditions, the battery, which serves as the power supply unit for electric motor cars or electronic devices, must be adaptive to these complex conditions. In addition, besides these conditions, the service life and charging/discharging cycle performance of battery must be considered; especially, when electric motor cars or electronic devices are used in low temperature environments, the battery must have outstanding low temperature charging/discharging performance and higher input/output power.

Usually, under low temperature conditions, the resistance of battery will increase, and the polarization will increase; therefore, the capacity of battery will be reduced.

To keep the capacity of battery and improve the charging/discharging performance of battery under low temperature conditions, the present invention provides a battery heating circuit.

### Summary of the Invention

The object of the present invention is to provide a battery heating circuit, in order to solve the problem of decreased capacity of battery caused by increased resistance and polarization of battery under low temperature conditions.

The battery heating circuit provided in the present invention, comprises a switch unit, a switching control module, a damping element R1, an energy storage circuit, and an energy limiting circuit, wherein, the energy storage circuit is connected with the battery, and comprises a current storage element L1 and a charge storage element C1; the damping element R1, the switch unit, the current storage element L1, and the charge storage element C1 are connected in series; the switching control module is connected with the switch unit, and is configured to control ON/OFF of the switch unit, so that the energy can flow to and fro between the battery and the energy storage circuit when the switch unit switches on; the energy limiting circuit is configured to limit the magnitude of current flowing from the energy storage circuit to the battery.

The heating circuit provided in the present invention can improve the charge/discharge performance of the battery; in addition, since the energy storage circuit is connected with the battery in series in the heating circuit, safety problem caused by overcurrent as short circuit related with failures of the switch unit can be avoided when the battery is heated due to the existence of the charge storage elements C1 connected in series, and therefore the battery can be protected effectively. Thus, the battery heating circuit provided in the present invention can avoid the safety problem caused by overcurrent in the heating circuit, so as to protect the battery efficiently. Further advantages, features, aspects and details are evident from the dependent claims, the description and the drawings.

Other characteristics and advantages of the present invention will be further detailed in the embodiments hereunder.

### Brief Description of the Drawings

The accompanying drawings are provided here to facilitate further understanding on the present invention, and are a part of this document. They are used together with the following embodiments to explain the present invention, but shall not be comprehended as constituting any limitation to the present invention. In the figures:
Figure 1 is a schematic diagram of the battery heating circuit provided in the present invention;
Figure 2 is a schematic diagram of an embodiment of the switch unit shown in Figure 1;
Figure 3 is a schematic diagram of an embodiment of the switch unit shown in Figure 1;
Figure 4 is a schematic diagram of a preferred embodiment of the battery heating circuit provided in the present invention;
Figure 5 is a schematic diagram of an embodiment of the energy superposition unit shown in Figure 4;
Figure 6 is a schematic diagram of an embodiment of the polarity inversion unit shown in Figure 5;
Figure 7 is a schematic diagram of an embodiment of the polarity inversion unit shown in Figure 5;
Figure 8 is a schematic diagram of an embodiment of the polarity inversion unit shown in Figure 5;
Figure 9 is a schematic diagram of an embodiment of the first DC-DC module shown in Figure 8;
Figure 10 is a schematic diagram of a preferred embodiment of the battery heating circuit provided in the present invention;
Figure 11 is a schematic diagram of a preferred embodiment of the battery heating circuit provided in the present invention;
Figure 12 is a schematic diagram of an embodiment of the electricity recharge unit shown in Figure 11;
Figure 13 is a schematic diagram of an embodiment of the second DC-DC module shown in Figure 12;
Figure 14 is a schematic diagram of a preferred embodiment of the battery heating circuit provided in the present invention;
Figure 15 is a schematic diagram of a preferred embodiment of the energy superposition and transfer unit shown in Figure 14;
Figure 16 is a schematic diagram of a preferred embodiment of the battery heating circuit provided in the present invention;
Figure 17 is a schematic diagram of an embodiment of the energy consumption unit shown in Figure 16;
Figure 18 is a schematic diagram of a preferred embodiment of the battery heating circuit provided in the present invention;
Figure 19 is a schematic diagram of the freewheeling circuit for the heating circuit shown in Figure 18;
Figure 20 is a schematic diagram of an embodiment of the battery heating circuit provided in the present invention;
Figure 21 is a timing sequence diagram of the waveform corresponding to the battery heating circuit shown in Figure 20;
Figure 22 is a schematic diagram of an embodiment of the battery heating circuit provided in the present invention;
Figure 23 is a timing sequence diagram of the waveform corresponding to the battery heating circuit shown in Figure 22;
Figure 24 is another timing sequence diagram of the waveform corresponding to the battery heating circuit shown in Figure 22;
Figure 25 is a schematic diagram of an embodiment of the battery heating circuit provided in the present invention;
Figure 26 is a timing sequence diagram of the waveform corresponding to the battery heating circuit shown in Figure 25;
Figure 27 is a first equivalent circuit diagram of the battery heating circuit shown in Figure 25 when the battery is charged in reverse direction;
Figure 28 is a second equivalent circuit diagram of the battery heating circuit shown in Figure 25 when the battery is charged in reverse direction;
Figure 29 is another timing sequence diagram of the waveform corresponding to the battery heating circuit shown in Figure 25.

### Detailed Description of the Embodiments

Hereunder the embodiments of the present invention will be detailed, with reference to the accompanying drawings. It should be appreciated that the embodiments described here are only provided to describe and explain the present invention, but shall not be deemed as constituting any limitation to the present invention.

Please note: unless otherwise specified, where mentioned in the following text, the term "switching control module" refers to any controller that can output control commands (e.g., pulse waveform) under preset conditions or at preset times and thereby controls the switch unit connected to it to switch on or switch off accordingly, for example, the switching control module can be a PLC; where mentioned in the following text, the term "switch" refers to a switch that achieve ON/OFF control by means of electrical signals or achieve ON/OFF control on the basis of the characteristics of the element or component, which is to say, the switch can be an one-way switch (e.g., a switch composed of a two-way switch and a diode connected in series, which can switch on in one direction) or a two-way switch (e.g., a Metal Oxide Semiconductor Field Effect Transistor (MOSFET) or an IGBT with an anti-parallel freewheeling diode); where mentioned in the following text, the term "two-way switch" refers to a switch that can switch on in two ways, which can achieve ON/OFF control by means of electrical signals or achieve ON/OFF control on the basis of the characteristics of the element or component, for example, the two-way switch can be a MOSFET or an IGBT with an anti-parallel freewheeling diode; where mentioned in the following text, the term "one-way semiconductor element" refers to a semiconductor element that can switch on in one direction, such as an diode; where mentioned in the following text, the term "charge storage element" refers to any device that can implement charge storage, such as a capacitor; where mentioned in the following text, the term "current storage element" refers to any device that can store current, such as an inductor; where mentioned in the following text, the term "forward direction" refers to the direction in which the energy flows from the battery to the energy storage circuit, and the term "reverse direction" refers to the direction in which the energy flows from the energy storage circuit to the battery; where mentioned in the following text, the term "battery" comprises primary battery (e.g., dry battery or alkaline battery, etc.) and secondary battery (e.g., lithium-ion battery, nickel-cadmium battery, nickel-hydrogen battery, or lead-acid battery, etc.); where mentioned in the following text, the term "damping element" refers to any device that inhibits current flowing and thereby achieves energy consumption, such as a resistor; where mentioned in the following text, the term "main loop" refers to a loop composed of battery, damping element, switch unit and energy storage circuit connected in series.

It should be noted specially: in view different types of batteries have different characteristics, in the present invention, the "battery" refers to an ideal battery that doesn't have internal parasitic resistance and inductance or has very low internal parasitic resistance and inductance, or refers to a battery pack that has internal parasitic resistance and inductance; therefore, those skilled in the art should appreciate: if the battery is an ideal battery that doesn't have internal parasitic resistance and inductance or has very low internal parasitic resistance and inductance, the damping element R refers to an damping element external to the battery; if the battery is a battery pack that has internal parasitic resistance and inductance, the damping element R refers to a damping element external to the battery, or refers to the parasitic resistance in the battery pack.

To ensure the normal service life of the battery, the battery can be heated under low temperature condition, which is to say, when the heating condition is met, the heating circuit is controlled to start heating for the battery; when the heating stop condition is met, the heating circuit is controlled to stop heating.

In the actual application of battery, the battery heating condition and heating stop condition can be set according to the actual ambient conditions, to ensure normal charging/discharging performance of the battery.

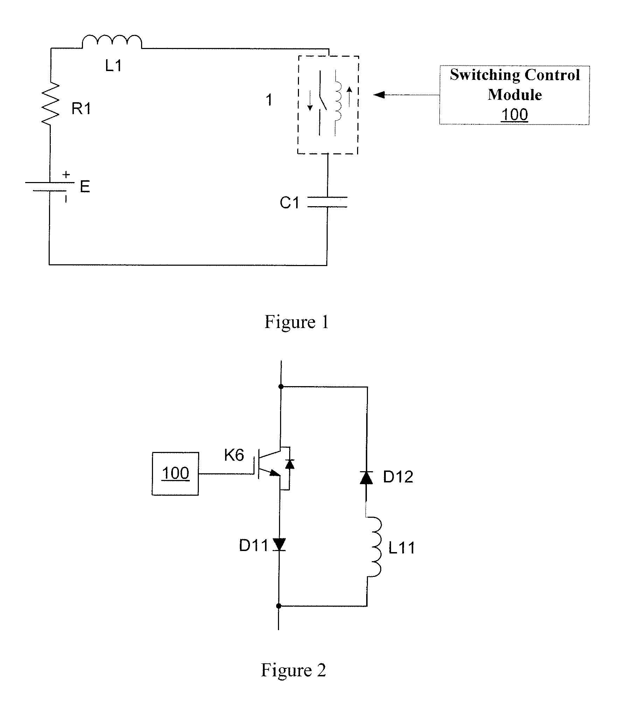

In order to heat up the battery E located in a low temperature environment, the present invention provides a battery heating circuit; as shown in figure 1, the battery heating circuit comprises a switch unit 1, a switching control module 100, a damping element R1, an energy storage circuit, and an energy limiting circuit, wherein, the energy storage circuit is connected with the battery, and comprises a current storage element L1 and a charge storage element C1; the damping element R1, the switch unit 1, the current storage element L1, and charge storage element C1 are connected in series; the switching control module 100 is connected with the switch unit 1, and is configured to control ON/OFF of the switch unit 1, so that the energy can flow to and fro between the battery and the energy storage circuit when the switch unit 1 switches on; the energy limiting circuit is configured to limit the magnitude of current flowing from the energy storage circuit to the battery.

It should be noted specially that in view different types of batteries have different characteristics, in the present invention, if the battery E has very high internal parasitic resistance and parasitic inductance, the damping element R1 could refers to the parasitic resistance in the battery pack; likewise, the current storage element L2 could refers to the parasitic inductance in the battery pack.

The switch unit 1 is connected in series with the energy storage circuit; when the switch unit 1 switches on, the energy can flows to and fro between the battery E and the energy storage circuit; the switch unit 1 can be implemented in a variety of ways, and the present invention doesn't define any limitation to the implementation of the switch unit. The switch unit may comprise a first one-way branch configured to implement energy flowing from the battery to the energy storage circuit, a second one-way branch configured to implement energy flowing from the energy storage circuit to the battery; the switching control module 100 is connected with either or both of the first one-way branch and second one-way branch, so as to control ON/OFF of the connected branches. The energy limiting circuit may comprise a current storage element L11, which is connected in series in the second one-way branch, and is configured to limit the amplitude of the current flowing to the battery E.

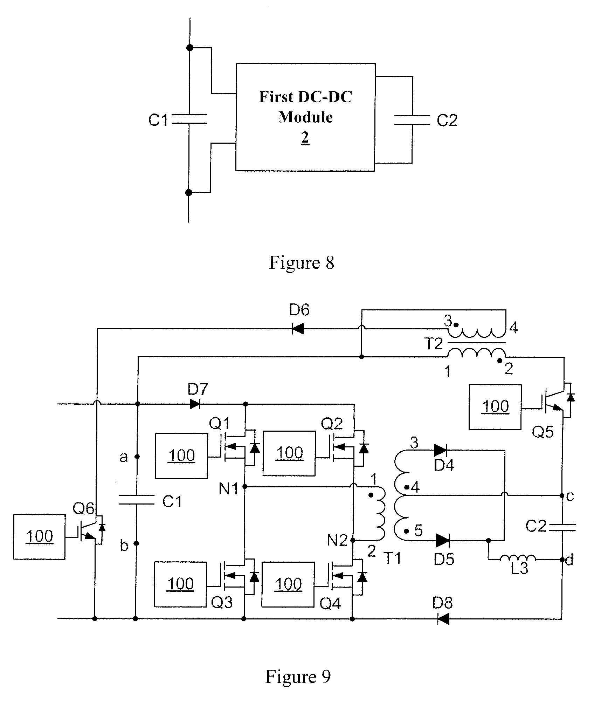

In an embodiment of switch unit 1, as shown in Figure 2, the switch unit 1 may comprise a switch K6, a one-way semiconductor element D11, and a one-way semiconductor element D12, wherein, the switch K6 and the one-way semiconductor element D11 are connected in series with each other to form the first one-way branch; the one-way semiconductor element D12 forms the second one-way branch; the switching control module 100 is connected with the switch K6, to control ON/OFF of the first one-way branch by controlling ON/OFF of the switch K6. In the switch unit 1 shown in Figure 8, when heating is required, the switch K6 can be controlled to switch on; when heating is not required, the switch K6 can be controlled to switch off.

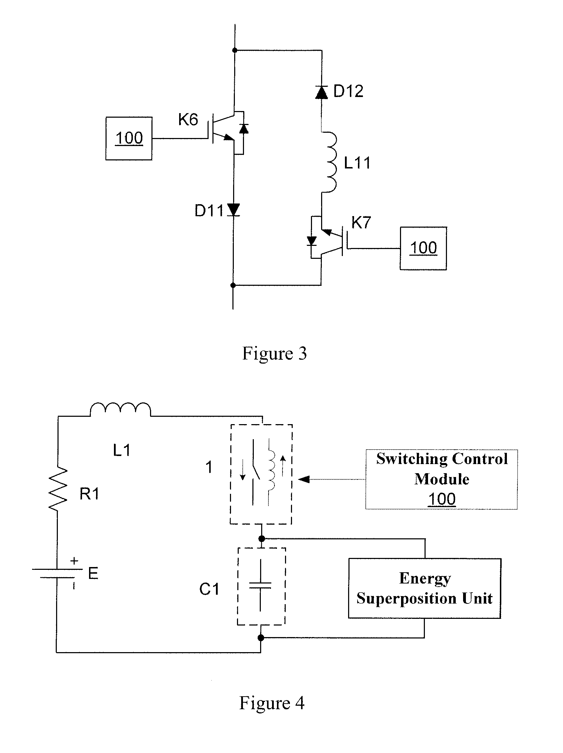

Though the implementation of switch unit 1 shown in Figure 2 enables to-and-fro energy flow along separate branches, it cannot enable energy flow cut-off function in reverse direction. The present invention further puts forward another embodiment of switch unit 1; as shown in Figure 3, the switch unit 1 can further comprise a switch K7 in the second one-way branch, wherein, the switch K7 is connected with the one-way semiconductor element D12 in series, the switching control module 100 is also connected with the switch K7, and is designed to control ON/OFF of the second one-way branch by controlling ON/OFF of the switch K7. Thus, in the switch unit I shown in Figure 3, since there are switches (i.e., switch K6 and switch K7) in both one-way branches, energy flow cut-off function in forward direction and reverse direction is enabled simultaneously.

The current storage element L11 is connected between the one-way semiconductor element D12 and the switch K7, to limit the current flowing to the battery E.

In the heating process described above, when the current flows from the energy storage circuit back to the battery E, the energy in the charge storage element C1 will not flow back to the battery E completely; instead, some energy will remain in the charge storage element C1, and ultimately the voltage across the charge storage element C1 is close or equal to the voltage of the battery, and therefore the energy flow from the battery E to the charge storage element C1 can't continue any more; that phenomenon is adverse to the cyclic operation of the heating circuit. Therefore, in a preferred embodiment of the present invention, an additional unit that implements the functions such as superposing the energy in the charge storage element C1 with the energy in the battery E, or transferring the energy in the charge storage element C1 to another energy storage element is added. At an appropriate time, the switch unit 1 is controlled to switch off, and the energy in the charge storage element C1 is superposed or transferred, for example. The switch unit 1 can be controlled to switch off at any time in one or more cycles; the switch unit 1 can be controlled to switch off at any time, for example, when the current flowing in the circuit is in forward direction/reverse direction, and when the current is zero or not zero. A specific implementation form of switch unit 1 can be selected, depending on the required cut-off strategy; if current flowing cut-off in forward direction is only required, the implementation form of switch unit 1 shown in Figure 2 can be selected; if current flowing cut-off in forward direction and reverse direction is required, the switch unit with two controllable one-way branches shown in Figure 3 can be selected. Preferably, the switching control module 100 is configured to control the switch unit 1 to switch off when the current flowing though the switch unit 1 is zero after the switch unit 1 switches on, so as to improve the working efficiency of the circuit. In addition, the disturbance to the entire circuit is minimal if the switch unit 1 switches off when the current flowing in the circuit is zero.

To improve heating efficiency, in a preferred embodiment of the present invention, as shown in Figure 4, the heating circuit provided in the present invention can comprise an energy superposition unit, which is connected with the energy storage circuit, and is designed to superpose the energy in the energy storage circuit with the energy in the battery E after the switch unit 1 switches on and then switches off. With the energy superposition unit, the discharging current in the heating loop can be increased when the switch unit 1 switches on again, and thereby the working efficiency of the heating circuit is improved.

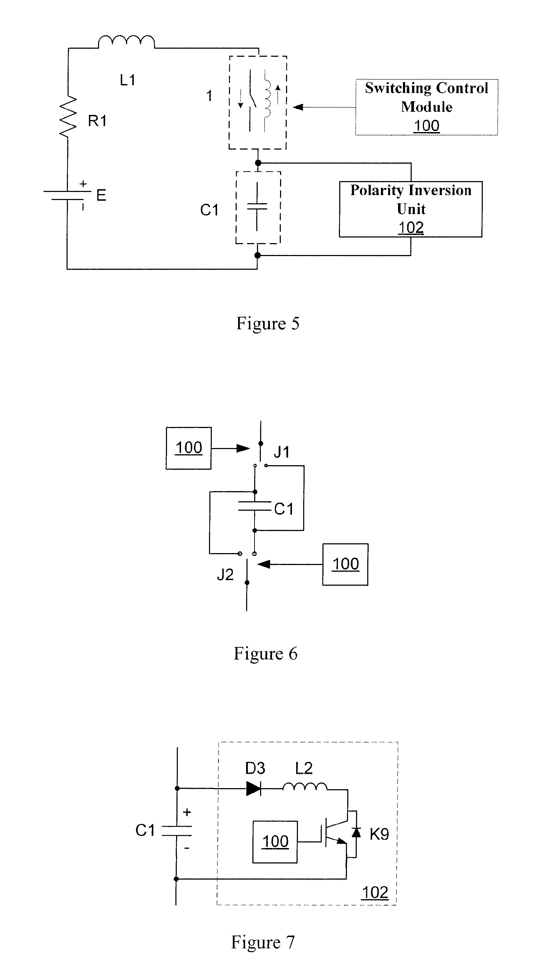

In an embodiment of the present invention, as shown in Figure 5, the energy superposition unit comprises a polarity inversion unit 102, which is connected with the energy storage circuit, and is designed to invert the voltage polarity of the charge storage element C 1 after the switch unit 1 switches on and then switches off. Since the voltage of the charge storage element C1 can be superposed in series with the voltage of the battery E after polarity inversion, the discharging current in the heating loop will be increased when the switch unit 1 switches on again.

As an embodiment of the polarity inversion unit 102, as shown in Figure 6, the polarity inversion unit 102 comprises a single pole double throw switch J1 and a single pole double throw switch J2 located on the two ends of the charge storage element C1 respectively; the input wires of the single pole double throw switch J1 are connected in the energy storage circuit, the first output wire of the single pole double throw switch J1 is connected with the first pole plate of the charge storage element C1, and the second output wire of the single pole double throw switch J1 is connected with the second pole plate of the charge storage element C1; the input wires of the single pole double throw switch J2 are connected in the energy storage circuit, the first output wire of the single pole double throw switch J2 is connected with the second pole plate of the charge storage element C1, and the second output wire of the single pole double throw switch J2 is connected with the first pole plate of the charge storage element C1; the switching control module 100 is also connected with the single pole double throw switch J1 and single pole double throw switch J2 respectively, and is designed to invert the voltage polarity of the charge storage element C1 by altering the connection relationships between the respective input wires and output wires of the single pole double throw switch J1 and the single pole double throw switch J2.

According to this embodiment, the connection relationships between the respective input wires and output wires of the single pole double throw switch J1 and single pole double throw switch J2 can be set in advance, so that the input wires of the single pole double throw switch J1 are connected with the first output wire of the switch unit K1 and the input wires of the single pole double throw switch J2 are connected with the first output wire of the switch unit K1 when the switch unit K1 switches on; the input wires of the single pole double throw switch J1 are switched to connect with the second output wire of the switch unit K1 and the input wires of the single pole double throw switch J2 are switched to connect with the second output wire of the switch unit K1 under control of the switching control module 100 when the switch unit K1 switches off, and thereby the voltage polarity of the charge storage element C1 is inverted.

As another embodiment of the polarity inversion unit 102, as shown in Figure 7, the polarity inversion unit 102 comprises a one-way semiconductor element D3, a current storage element L2, and a switch K9; the charge storage element C1, current storage element L2, and switch K9 are connected sequentially in series to form a loop; the one-way semiconductor element D3 is connected in series between the charge storage element C1 and the current storage element L2 or between the current storage element L2 and the switch K9; the switching control module 100 is also connected with the switch K9, and is designed to invert the voltage polarity of the charge storage element C1 by controlling the switch K9 to switch on.

According to the above embodiment, when the switch unit 1 switches off, the switch K9 can be controlled to switch on by the switching control module 100, and thereby the charge storage element C1, one-way semiconductor element D3, current storage element L2, and switch K9 form a LC oscillation loop, and the charge storage element C1 discharges through the current storage element L2, thus, the voltage polarity of the charge storage element C1 will be inverted when the current flowing through the current storage element L2 reaches to zero after the current in the oscillation circuit flows through the positive half cycle.

As yet another embodiment of the polarity inversion unit 102, as shown in Figure 8, the polarity inversion unit 102 comprises a first DC-DC module 2 and a charge storage element C2; the first DC-DC module 2 is connected with the charge storage element C1 and the charge storage element C2 respectively; the switching control module 100 is also connected with the first DC-DC module 2, and is designed to transfer the energy in the charge storage element C1 to the charge storage element C2 by controlling the operation of the first DC-DC module 2, and then transfer the energy in the charge storage element C2 back to the charge storage element C1, so as to invert the voltage polarity of the charge storage element C1.

The first DC-DC module 2 is a DC-DC( direct current to direct current ) conversion circuit for voltage polarity inversion commonly used in the field. The present invention doesn't make any limitation to the specific circuit structure of the first DC-DC module 2, as long as the module can accomplish voltage polarity inversion of the charge storage element C1. Those skilled in the art can add, substitute, or delete the elements in the circuit as required.

Figure 9 shows an embodiment of the first DC-DC module 2 provided in the present invention. As shown in Figure 9, the first DC-DC module 2 comprises: a two-way switch Q1, a two-way switch Q2, a two-way switch Q3, a two-way switch Q4, a first transformer T1, an one-way semiconductor element D4, an one-way semiconductor element D5, a current storage element L3, a two-way switch Q5, a two-way switch Q6, a second transformer T2, an one-way semiconductor element D6, an one-way semiconductor element D7, and an one-way semiconductor element D8.

In the embodiment, the two-way switch Q1, two-way switch Q2, two-way switch Q3, and two-way switch Q4 are MOSFETs, and the two-way switch Q5 and two-way switch Q6 are IGBTs.

The Pin 1, 4, and 5 of the first transformer T1 are dotted terminals, and the pin 2 and 3 of the second transformer T2 are dotted terminals.

Wherein, the positive electrode of the one-way semiconductor element D7 is connected with the end 'a' of the charge storage element C1, and the negative electrode of the one-way semiconductor element D7 is connected with the drain electrodes of the two-way switch Q1 and two-way switch Q2, respectively; the source electrode of the two-way switch Q1 is connected with the drain electrode of the two-way switch Q3, and the source electrode of the two-way switch Q2 is connected with the drain electrode of the two-way switch Q4; the source electrodes of the two-way switch Q3 and two-way switch Q4 are connected with the end 'b' of the charge storage element C1 respectively. Thus, a full-bridge circuit is formed, here, the voltage polarity of end 'a' of the charge storage element C1 is positive, while the voltage polarity of end 'b' of the charge storage element C1is negative.

In the full-bridge circuit, the two-way switch Q1, two-way switch Q2 constitute the upper bridge arm, while the two-way switch Q3 and two-way switch Q4 constitute the lower bridge arm. The full-bridge circuit is connected with the charge storage element C2 via the first transformer T1; the pin 1 of the first transformer T1 is connected with the first node N1, the pin 2 of the first transformer T1 is connected with the second node N2, the pin 3 and pin 5 of the first transformer T1 are connected to the positive electrode of the one-way semiconductor element D4 and the positive electrode of the one-way semiconductor element D5 respectively; the negative electrode of one-way semiconductor element D4 and the negative electrode of one-way semiconductor element D5 are connected with one end of the current storage element L3, and the other end of the current storage element L3 is connected with the end 'd' of the charge storage element C2; the pin 4 of the transformer T1 is connected with the end 'c' of the charge storage element C2, the positive electrode of the one-way semiconductor element D8 is connected with the end 'd' of the charge storage element C2, and the negative electrode of the one-way semiconductor element D8 is connected with the end 'b' of the charge storage element C1; here, the voltage polarity of end 'c' of the charge storage element C2 is negative, while the voltage polarity of end 'd' of the charge storage element C2 is positive.

Wherein, the end 'c' of the charge storage element C2 is connected with the emitter electrode of the two-way switch Q5, the collector electrode of the two-way switch Q5 is connected with the pin 2 of the transformer T2, the pin I of the transformer T2 is connected with end 'a' of the charge storage element C1, the pin 4 of the transformer T2 is connected with end 'a' of the charge storage element C1, the pin 3 of the transformer T2 is connected with the positive electrode of the one-way semiconductor element D6, the negative electrode of the one-way semiconductor element D6 is connected with the collector electrode of the two-way switch Q6, and the emitter electrode of the two-way switch Q6 is connected with the end 'b' of the charge storage element C2.

Wherein, the two-way switch Q1, two-way switch Q2, two-way switch Q3, two-way switch Q4, two-way switch Q5, and two-way switch Q6 are controlled by the switching control module 100 respectively to switch on and switch off.

Hereafter the working process of the first DC-DC module 2 will be described:
1. After the switch unit 1 switches off, the switching control module 100 controls the two-way switch Q5 and two-way switch Q6 to switch off, and controls the two-way switch Q1 and two-way switch Q4 to switch on at the same time to form phase A; controls the two-way switch Q2 and two-way switch Q3 to switch on at the same time to form phase B. Thus, by controlling the phase A and phase B to switch on alternately, a full-bridge circuit is formed;
2. When the full-bridge circuit operates, the energy in the charge storage element C1 is transferred through the first transformer T1, one-way semiconductor element D4, one-way semiconductor element D5, and current storage element L3 to the charge storage element C2; now, the voltage polarity of end 'c' of the charge storage element C2 is negative, while the voltage polarity of end 'd' of the charge storage element C2 is positive.
3. The switching control module 100 controls the two-way switch Q5 to switch on, and therefore a path from the charge storage element C1 to the charge storage element C2 is formed via the second transformer T2 and the one-way semiconductor element D8, thus, the energy in the charge storage element C2 is transferred back to the charge storage element C1, wherein, some energy will be stored in the second transformer T2, Now, the switching control module 100 controls the two-way switch Q5 to switch off and controls the two-way switch Q6 to switch on, and therefore the energy stored in the second transformer T2 is transferred to the charge storage element C1 by the second transformer T2 and the one-way semiconductor element D6; now, the voltage polarity of the charge storage element C1 is inverted such that end 'a' is negative and end 'b' is positive. Thus, the purpose of inverting the voltage polarity of the charge storage element C1 is attained.

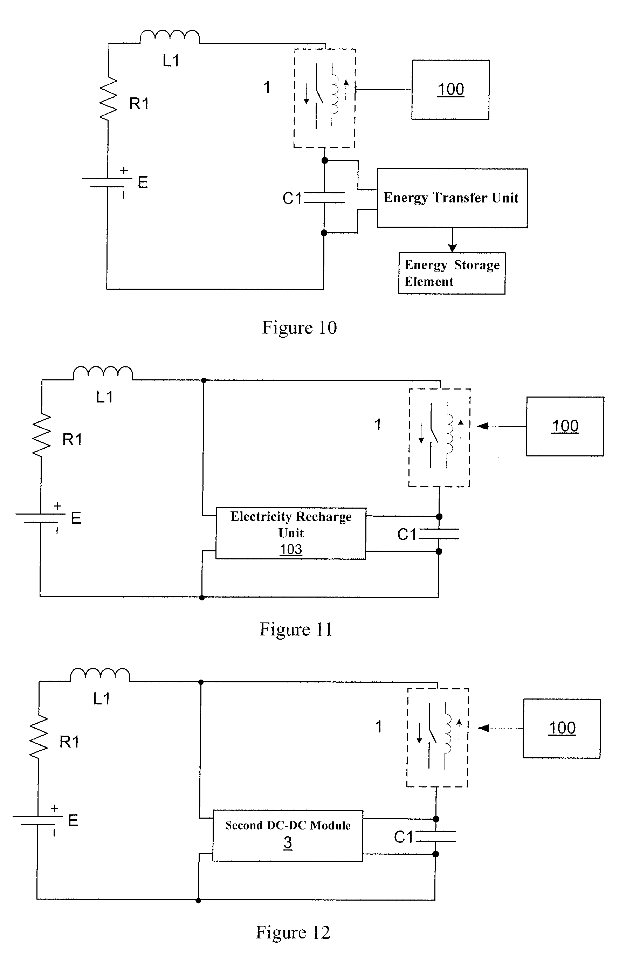

To recycle the energy in the energy storage circuit, in a preferred embodiment of the present invention, as shown in Figure 10, the heating circuit provided in the present invention may comprise an energy transfer unit, which is connected with the energy storage circuit, and is designed to transfer the energy in the energy storage circuit to the energy storage element after the switch unit 1 switches on and then switches off. The purpose of the energy transfer unit is to recycle the energy in the energy storage circuit. The energy storage element can be an external capacitor, a low temperature battery or electric network, or an electrical device.

Preferably, the energy storage element is the battery E provided in the present invention, the energy transfer unit comprises an electricity recharge unit 103, which is connected with the energy storage circuit, and is designed to transfer the energy in the energy storage circuit to the battery E after the switch unit 1 switches on and then switches off, as shown in Figure 11.

In the technical solution of the present invention, after the switch unit 1 switches off, the energy in the energy storage circuit is transferred by the energy transfer unit to the battery E, so that the transferred energy can be recycled after the switch unit 1 switches on again, and thereby the working efficiency of the heating circuit is improved.

In an embodiment of the electricity recharge unit 103, as shown in Figure 12, the electricity recharge unit 103 comprises a second DC-DC module 3, which is connected with the charge storage element C1 and the battery E respectively; the switching control module 100 is also connected with the second DC-DC module 3, and is designed to control the operation of the second DC-DC module 3, so as to transfer the energy in the charge storage element C1 to the battery E.

The second DC-DC module 3 is a DC-DC (direct current to direct current) conversion circuit for energy transfer commonly used in the field. The present invention doesn't make any limitation to the specific circuit structure of the second DC-DC module 3, as long as the module can transfer the energy in the charge storage element C1. Those skilled in the art can add, substitute, or delete the elements in the circuit as required.

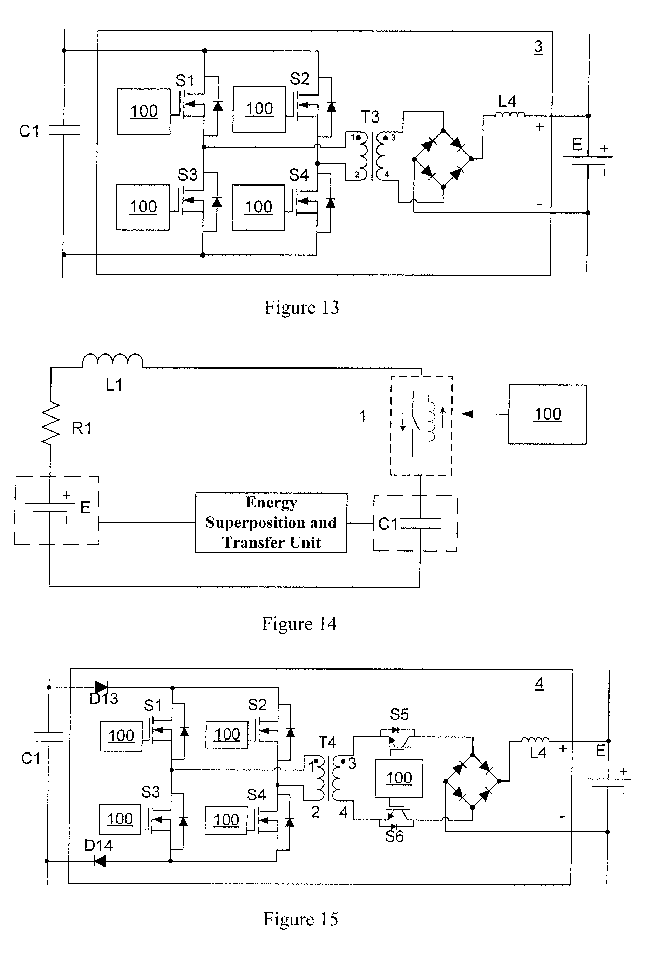

Figure 13 shows an embodiment of the second DC-DC module 3 provided in the present invention. As shown in Figure 13, the second DC-DC module 3 comprises: a two-way switch S1, a two-way switch S2, a two-way switch S3, a two-way switch S4, a third transformer T3, a current storage element L4, and four one-way semiconductor elements. In the embodiment, the two-way switch S1, two-way switch S2, two-way switch S3, and two-way switch S4 are MOSFETs.

Wherein, the pin 1 and pin 3 of the third transformer T3 are dotted terminals; the negative electrodes of two one-way semiconductor elements among the four one-way semiconductor elements are connected into a group and their junction point is connected with the positive pole of the battery E through the current storage element L4; the positive electrodes of the other two one-way semiconductor elements are connected into a group and their junction point is connected with the negative pole of the battery E; in addition, the junction points between the groups are connected with pin 3 and pin 4 of the third transformer T3 respectively, and thereby form a bridge rectifier circuit.

Wherein, the source electrode of the two-way switch S1 is connected with the drain electrode of the two-way switch S3, the source electrode of the two-way switch S2 is connected with the drain electrode of the two-way switch S4, the drain electrodes of the two-way switch S1 and two-way switch S2 are connected with the positive end of the charge storage element C1 respectively, the source electrodes of the two-way switch S3 and two-way switch S4 are connected with the negative end of the charge storage element C1 respectively; thus, a full-bridge circuit is formed.

In the full-bridge circuit, the two-way switch S1 and two-way switch S2 constitute the upper bridge arm, and the two-way switch S3 and two-way switch S4 constitute the lower bridge arm; the pin 1 of the third transformer T3 is connected with the node between two-way switch S1 and two-way switch S3, and the pin 2 of the third transformer T3 is connected with the node between two-way switch S2 and two-way switch S4.

Wherein, the two-way switch S1, two-way switch S2, two-way switch S3, and two-way switch S4 are controlled by the switching control module 100 respectively to switch on and switch off.

Hereafter the working process of the second DC-DC module 3 will be described:
1. After the switch unit 1 switches off, the switching control module 100 controls the two-way switch S1 and two-way switch S4 to switch on at the same time to form phase A; and controls the two-way switch S2 and two-way switch S3 to switch on at the same time to form phase B. Thus, by controlling the phase A and phase B to switch on alternately, a full-bridge circuit is formed;
2. When the full-bridge circuit operates, the energy in charge storage element C1 is transferred to the battery E through the third transformer T3 and rectifier circuit; and the rectifier circuit converts the AC input into DC and outputs the DC to the battery E, to attain the purpose of electricity recharge.

In order to improve the working efficiency of the heating circuit while achieve energy recycling for the energy storage circuit, in a preferred embodiment of the present application, as shown in Figure 14, the heating circuit of the present application may comprises an energy superposition and transfer unit, the energy superposition and transfer unit is connected with the energy storage circuit, and is designed to transfer the energy in the energy storage circuit to an energy storage element after the switch unit 1 switches on and then switches off, and then superpose the remaining energy in the energy storage circuit with the energy in the battery E. Through energy transfer, energy recycling is achieved, and through energy superposition, the discharging current in the heating loop will be increased when the switch unit 1 switches on again, and thereby the working efficiency of the heating circuit can be improved.

The superposition of the remaining energy in the energy storage circuit with the energy in the battery can be implemented by inverting the voltage polarity of the charge storage element C1; after polarity inversion, the voltage across the charge storage element C1 can be added in series with the voltage of the battery E; thus, when the switch unit 1 switches on at the next time, the energy in the battery E can be superposed with the energy in the charge storage element C1.

Therefore, according to an embodiment of the present invention, as shown in Figure 15, in the heating circuit provided in the present invention, the energy superposition and transfer unit comprises a DC-DC module 4, which is connected with the charge storage element C1 and the battery E respectively; the switching control module 100 is also connected with the DC-DC module 4, and is designed to transfer the energy in the charge storage element C1 to an energy storage element by controlling the operation of the DC-DC module 4, and then superpose the remaining energy in the charge storage element C1 with the energy in the battery E. In that embodiment, the energy storage element is the battery E.

The DC-DC module 4 is a DC-DC (direct current to direct current) conversion circuit for energy transfer and voltage polarity inversion commonly used in the field. The present invention doesn't make any limitation to the specific circuit structure of the DC-DC module 4, as long as the module can accomplish energy transfer from the charge storage element C1 and voltage polarity inversion of the charge storage element C1. Those skilled in the art can add, substitute, or delete the elements in the circuit as required.

In an embodiment of the DC-DC module 4, as shown in Figure 15, the DC-DC module 4 comprises: a two-way switch S1, a two-way switch S2, a two-way switch S3, a two-way switch S4, a two-way switch S5, a two-way switch S6, a fourth transformer T4, an one-way semiconductor element D13, an one-way semiconductor element D14, a current storage element L4, and four one-way semiconductor elements. In that embodiment, the two-way switch S1, two-way switch S2, two-way switch S3, and two-way switch S4 are MOSFETs, while the two-way switch S5 and two-way switch S6 are IGBTs.

Wherein, the pin 1 and pin 3 of the fourth transformer T3 are dotted terminals; the negative electrodes of two one-way semiconductor elements among the four one-way semiconductor elements are connected into a group and their junction point is connected with the positive pole of the battery E through the current storage element L4; the positive electrodes of the other two one-way semiconductor elements are connected into a group and their junction point is connected with the negative pole of the battery E; in addition, the junction points between the groups are connected with pin 3 and pin 4 of the third transformer T3 via two-way switch S5 and two-way switch S6 respectively, and thereby form a bridge rectifier circuit.

Wherein, the source electrode of the two-way switch S1 is connected with the drain electrode of the two-way switch S3, the source electrode of the two-way switch S2 is connected with the drain electrode of the two-way switch S4, the drain electrodes of the two-way switch S1 and two-way switch S2 are connected with the positive end of the charge storage element C1 via the one-way semiconductor element D13, the source electrodes of the two-way switch S3 and two-way switch S4 are connected with the negative end of the charge storage element C1 via the one-way semiconductor element D14; thus, a full-bridge circuit is formed.

In the full-bridge circuit, the two-way switch S1 and two-way switch S2 constitute the upper bridge arm, and the two-way switch S3 and two-way switch S4 constitute the lower bridge arm; the pin 1 of the fourth transformer T4 is connected with the node between two-way switch S1 and two-way switch S3, and the pin 2 of the fourth transformer T4 is connected with the node between two-way switch S2 and two-way switch S4.

Wherein, the two-way switch S1, two-way switch S2, two-way switch S3, and two-way switch S4, two-way switch S5, and two-way switch S6 are controlled by the switching control module 100 respectively to switch on and switch off.

Hereafter the working process of the DC-DC module 4 will be described:
1. After the switch unit 1 switches off, when electricity recharging is to be performed from the charge storage element C1 (i.e., transferring the energy from the charge storage element C1 back to the battery E) so as to accomplish energy transfer, the switching control module 100 controls the two-way switch S5 and S6 to switch on, and controls the two-way switch S1 and two-way switch S4 to switch on at the same time, to constitute phase A; the switching control module 100 controls the two-way switch S2 and two-way switch S3 to switch on at the same time, to constitute phase B. Thus, by controlling the phase A and phase B to switch on alternately, a full-bridge circuit is formed;
2. When the full-bridge circuit operates, the energy in charge storage element C1 is transferred to the battery E through the fourth transformer T4 and rectifier circuit; the rectifier circuit converts the AC input into DC and outputs the DC to the battery E, to attain the purpose of electricity recharging;
3. When polarity inversion of the charge storage element C1 is to be performed to accomplish energy superposition, the switching control module 100 controls the two-way switch S5 and two-way switch S6 to switch off, and controls either of the two groups (two-way switch S1 and two-way switch S4, or two-way switch S2 and two-way switch S3) to switch on; now, the energy in the charge storage element C1 flows through the positive end of charge storage element C1, two-way switch S1, primary side of the fourth transformer T4, and two-way switch S4 back to the negative end of the charge storage element C1, or flows through the positive end of charge storage element C1, two-way switch S2, primary side of the fourth transformer T4, and two-way switch S3 back to the negative end of the charge storage element C1. Thus, the purpose of voltage polarity inversion of charge storage element C1 is attained by means of the magnetizing inductance at the primary side of T4.

In another embodiment, in the heating circuit provided in the present invention, the energy superposition and transfer unit can comprise an energy superposition unit and an energy transfer unit, wherein, the energy transfer unit is connected with the energy storage circuit, and is designed to transfer the energy in the energy storage circuit to an energy storage element after the switch unit 1 switches on and then switches off; the energy superposition unit is connected with the energy storage circuit, and is designed to superpose the remaining energy in the energy storage circuit with the energy in the battery E after the energy transfer unit performs energy transfer.

Wherein, the energy superposition unit and the energy transfer unit can be the energy superposition unit and the energy transfer unit provided in the embodiments of the present invention described above, for the purpose of transferring and superposing the energy in the charge storage element C1. The structure and function of the energy superposition unit and the energy transfer unit will not be detailed further here.

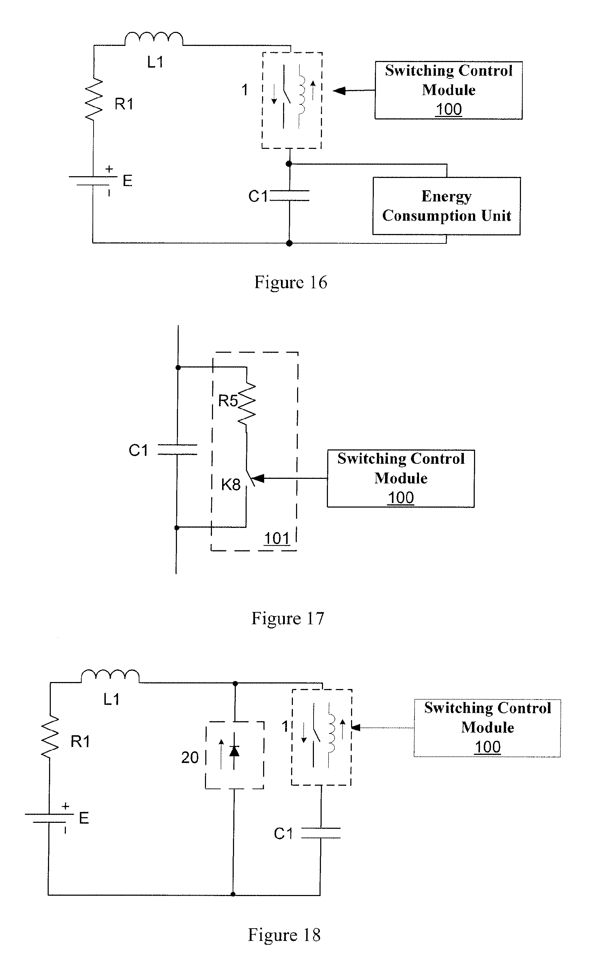

In an embodiment of the present invention, the improvement of working efficiency of the heating circuit could be achieved by consuming the energy in the charge storage element C1. Thus, as shown in Figure 16, the heating circuit further comprises an energy consumption unit, which is connected with the charge storage element C1, and is designed to consume the energy in the charge storage element C1 after the switch unit 1 switches on and then switches off.

The energy consumption unit can be used separately in the heating circuit, to consume the energy in the charge storage element C1 directly after the switch unit 1 switches on and then switches off; or, it can be integrated into the embodiments described above, for example, it can be integrated into the heating circuit that comprises an energy superposition unit, so as to consume the energy in the charge storage element C1 after the switch unit 1 switches on and then switches off and before the energy superposition unit performs energy superposition; or, it can be integrated into the heating circuit that comprises an energy transfer unit, so as to consume the energy in the charge storage element C1 after the switch unit 1 switches on and then switches off and before or after the energy transfer unit performs energy transfer; likewise, it can be integrated into the heating circuit that comprises an energy superposition and transfer unit, so as to consume the energy in the charge storage element C1 after the switch unit 1 switches on and then switches off and before the energy superposition and transfer unit performs energy transfer, or consume the energy in the charge storage element C1 after the switch unit 1 switches on and then switches off and after the energy superposition and transfer unit performs energy transfer and before the energy superposition and transfer unit performs energy superposition; the present invention dose not define any limitation to the specific implementation of the energy consumption unit. Moreover, the working process of the energy consumption unit can be understood more clearly in the following embodiments.

In an embodiment , as shown in Figure 17 , the energy consumption unit comprises a voltage control unit 101, which is designed to convert the voltage across the charge storage element C1 to a predetermined value of voltage after the switch unit 1 switches on and then switches off. The predetermined value of voltage can be set as required.

In an embodiment of the present invention, as shown in Figure 17, the voltage control unit 101 comprises a damping element R5 and a switch K8, wherein, the damping element R5 and switch K8 are connected with each other in series, and then connected in parallel across the charge storage element C1; the switching control module 100 is also connected with the switch K8, and is designed to control the switch K8 to switch on after the switch unit 1 switches on and then switches off. Thus, the energy in the charge storage element C1 can be consumed across the damping element R5.

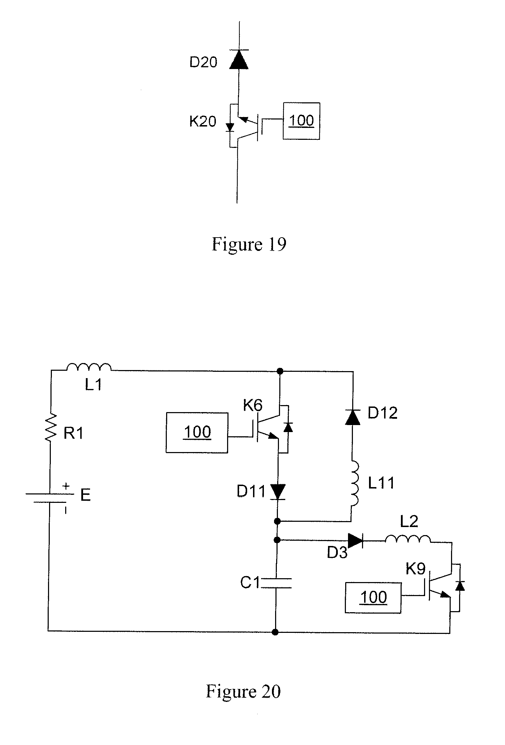

Due to the existence of the current storage element, high induced electromotive force may be generated in the inductive elements such as current storage elements L1 and L11 because the sudden change of current to zero if the switch unit switches off when there is current flowing from the energy storage circuit to the battery, and the high induced electromotive force may damage other circuit elements such as switch unit 1 in the circuit. In view of above problem, preferably, as shown in Figure 18, the heating circuit for battery E provided in the present invention further comprises a freewheeling circuit 20, which starts operation when the switch unit 1 switches off during current flowing from the energy storage circuit to the battery E, so as to protect other circuit elements in the circuit. As shown in Figure 19, the freewheeling circuit 20 can comprise a switch K20 and a one-way semiconductor element D20 connected in series with each other; the switching control module 100 is connected with the switch K20, and is configured to control the switch K20 to switch on after the switch unit 1 switches off when there is current flowing from the energy storage circuit to the battery, and control the switch K20 to switch off when the current flowing from the energy storage circuit to the battery reaches to a predetermined current value. One end of the freewheeling circuit 20 can be connected between the current storage element L1 and the switch unit 1, and the other end of the freewheeling circuit 20 can be connected to the negative electrode of the battery. Since the heating circuit provided in the present invention has a current storage element L1 that limits the energy in the second one-way branch of the switch unit 1, besides the current storage element L1 in the main loop, preferably, one end of the freewheeling circuit 20 is connected to the negative electrode of the battery, and the other end of the freewheeling circuit 20 is connected to the second one-way branch, so that the freewheeling current flows through the current storage element L11. For example, in an embodiment that utilizes the switch unit 1 shown in Figure 2, one end of the freewheeling circuit 20 is connected between the one-way semiconductor element D12 and the current storage element L11, and the other end of the freewheeling circuit 20 is connected to the negative electrode of the battery E; in an embodiment that utilizes the switch unit 1 shown in Figure 3, one end of the freewheeling circuit 20 is connected between the switch K7 and the current storage element L11, and the other end of the freewheeling circuit 20 is connected to the negative electrode of the battery E, so that better current freewheeling effect is attained.

In order to reduce the number of elements/components and reduce the size of the heating circuit, a preferred embodiment is further provided in the present invention, so that the current storage element L11 for energy limitation can also be used in the polarity inversion unit 102, to take a role in the voltage polarity inversion of the charge storage element C1. In the preferred embodiment, as shown in Figure 25, the switch unit 1 can be in the form of the switch unit shown in Figure 5, and the current storage element L11 for energy limitation is connected in series between the one-way semiconductor element D12 and the switch K7 in the second one-way branch of the switch unit 1; the heating circuit further comprises a one-way semiconductor element D15, a one-way semiconductor element D16, a switch K10, and a switch K11; the negative electrode of the one-way semiconductor element D16 is connected between the switch K7 and the charge storage element L11, the positive electrode of the one-way semiconductor element D16 is connected to one end of the switch K11, and the other end of the switch K11 is connected to the negative electrode of the battery; the positive electrode of the one-way semiconductor element D15 is connected between the one-way semiconductor element D12 and the charge storage element L11, the negative electrode of the one-way semiconductor element D15 is connected to one end of the switch K10, and the other end of the switch K10 is connected to the negative electrode of the battery; the switching control module 100 is also connected with the switch K10 and switch K11, and is configured to control ON/OFF of the switch K10 and switch K11.

In the preferred embodiment, the switching control module 100 can control the switches K6, K7, K10, and K11 with a variety of ON/OFF strategies, as long as the energy can flow between the battery E and the charge storage element C1 and the voltage across the charge storage element C1 can be inverted. For example, in an embodiment, when the battery is to be heated, the switching control module 100 controls the switch K6 and switch K7 to switch on, so that the energy flows from the battery to the charge storage element C1, and then flows from the charge storage element C1 back to the battery (wherein, the switch K6 and switch K7 can be controlled to switch on at the same time, or the switch K7 can be controlled to switch on after the switch K6 switches on); when the voltage across the charge storage element C1 reaches to a first preset value which is higher than the voltage of the battery, the switch K7 switches off and the switch K11 switches on; when the current flowing through the current storage element L11 is zero, the switch K11 switches off, and the switch K7 and switch K10 switch on, so that the voltage polarity of the charge storage element C1 is inverted. For example, in another embodiment, when the battery is to be heated, the switching control module 100 controls the switch K6 and switch K7 to switch on, so that the energy flows from the battery to the charge storage element C1, and then flows from the charge storage element C1 back to the battery; when the voltage across the charge storage element C1 reaches to a second preset value which is lower than or equal to the voltage of the battery, the switch K7 switches off, and the switch K11 switches on; when the current flowing through the current storage element L11 reaches to a second set value of current, the switch K11 switches off, and the switch K7 and switch K10 switch on; when the current flowing through the current storage element L11 reaches to a first set value of current, the switch K10 switches off, so that the energy in the current storage element L11 flows to the battery; when the current flowing through the current storage element L11 is zero, the switch K7 and switch K10 switch on, so that the voltage polarity of the charge storage element C1 is inverted.

The switching control module 100 can be a separate controller, which, by means of internal program setting, enables ON/OFF control of different external switches; or, the switching control module 100 can be a plurality of controllers, for example, a switching control module 100 can be set for each external switch correspondingly; or, the plurality of switching control modules 100 can be integrated into an assembly. The present invention does not define any limitation to the forms of implementation of the switching control module 100.

Hereunder the working process of the embodiments of the heating circuit for battery E will be introduced briefly with reference to Figure 20-29, wherein, Figure 20, 22, and 25 show different embodiments of the heating circuit for battery E, while Figure 21, 23, and 24, and Figure 26 and 29 shown the corresponding wave patterns. It should be noted: though the features and elements of the present invention are described specifically with reference to Figure 20, 22, and 25, each feature or element of the present invention can be used separately without other features and elements, or can be used in combination or not in combination with other features and elements. The embodiments of the heating circuit for battery E provided in the present invention are not limited to those shown in Figure 20, 22, and 25. The grid parts of the wave patterns shown in Figure 21, 23, and 24, and Figure 26 and 29 indicate drive pulses can be applied to the switch in one or more times within the period, and the pulse width can be adjusted as required.

In the heating circuit for battery E shown in Figure 20, the switch K6 and one-way semiconductor element D11 are connected in series to constitute a first one-way branch of the switch unit; the one-way semiconductor element D12 constitutes the second one-way branch of the switch unit 1, the current storage element L11 is arranged as an energy limiting circuit in the second one-way branch, and is connected in series with the one-way semiconductor element D12, the one-way semiconductor element D3, current storage element 12, and switch K9 constitute an polarity inversion unit 102, the switching control module 100 can control ON/OFF of the switch K9 and K6. Figure 21 shows the wave pattern of the current Imain in the main loop of the heating circuit shown in Figure 20, voltage V_{C1} across C1, and current I_{L2} in the polarity inversion loop. The working process of the heating circuit shown in Figure 20 is as follows:
a) The switching control module 100 controls the switch K6 to switch on, and therefore the battery E discharges in forward direction through the switch K6, one-way semiconductor element D11, and charge storage element C1 (as indicated by the time period t1 shown in Figure 2), and is charged in reverse direction through the current storage element L11 and one-way semiconductor element D 12 (as indicated by the time period t2 shown in Figure 21); it is seen from the time period t2 in Figure 21: due to the existence of the current storage element L11, the current in the main loop is limited at a smaller value when the battery is charged.
b) The switching control module 100 controls the switch K6 to switch off when the current in reverse direction is zero.
c) The switching control module 100 controls the switch K9 to switch on, and therefore the polarity inversion unit 102 starts operation; the charge storage element C1 discharges through the circuit composed by the one-way semiconductor element D3, current storage element L2, and switch K9, to attain the purpose of voltage polarity inversion; then, the switching control module 100 controls the switch K9 to switch off, as indicated by the time period t3 shown in Figure 21.
d) Repeat step a) to step c); the battery E is heated up continuously while it discharges and is charged, till the battery E meets the heating stop condition.

In the heating circuit for battery E shown in Figure 22, the switch K6 and one-way semiconductor element D11 are connected in series to constitute a first one-way branch of the switch unit 1, the one-way semiconductor element D12 and the switch K7 constitute the second one-way branch for the switch unit 1, the current storage element L11 is connected in series between the one-way semiconductor element D12 and the switch K7, to attain the purpose of current limitation; the one-way semiconductor element D3, current storage element L2, and switch K20 are connected in series to constitute a freewheeling circuit, one end of the freewheeling circuit is connected between the current storage element L11 and the switch K7 in the second one-way branch, and the other end of the freewheeling circuit is connected to the negative electrode of the battery; the switching control module 100 can control ON/OFF of switch K6, switch K7, switch K9, and switch K20. Figure 23 and Figure 24 show the wave patterns of the current in main loop Iₘₐᵢₙ, voltage V_{C1} across C1, and current I_{L2} of the polarity inversion loop; in a cycle shown in Figure 23, switch K7 switches on and switches off once; when the switch K7 switches off, the diode D20 sustains the current once; in the reversed charging process of battery E in a cycle in Figure 24, the switch K7 is controlled to switch on and switch off in multiple times, and the current is sustained from the diode D20 whenever the switch K7 switches off. The working process of the heating circuit shown in Figure 22 is as follows:
a) The switching control module 100 controls the switch K6 to switch on, and thus the battery E discharges in forward direction through the switch K6, one-way semiconductor element D11, and charge storage element C1 (as indicated by the time period t1 shown in Figure 23 and Figure 24), when the discharge in forward direction is completed, the switching control module 100 controls the switch K7 to switch on (as shown in Figure 23), or controls K7 to switch on and switch off for several times (as shown in Figure 24); the charge storage element C1 charges the battery E in reverse direction through the switch K7, current storage element L1, and one-way semiconductor element D12 (as indicated by the time period t2 in Figure 23 and 24); due to the existence of the current storage element L11, the amplitude of current flowing to battery E is limited, and the switching control module 100 controls the switch K20 to switch on, so that the diode D20 takes an role for current freewheeling when the switch K7 switches off, as indicated by the time period t2 in Figure 23 and 24;
b) The switching control module 100 controls the switch K6 and K20 to switch off when the current in reverse direction is the predetermined current value (e.g., zero).
c) The switching control module 100 controls the switch K9 to switch on, and therefore the polarity inversion unit 102 starts operation; the charge storage element C1 discharges through the loop composed by the one-way semiconductor element D3, current storage element L2, and switch K9, to attain the purpose of voltage polarity inversion of the charge storage element C1; then, the switching control module 100 controls the switch K9 to switch off, as indicated by the time period t3 shown in Figure 23 and 24;
d) Repeat step a) to step c); the battery E is heated up continuously while it discharges and is charged, till the battery E meets the heating stop condition.

In the heating circuit shown in Figure 25, the switch K6 and one-way semiconductor element D11 are connected in series with each other to constitute the first one-way branch of the switch unit I, the one-way semiconductor element D12 and switch K7 constitute the second one-way branch of the switch unit 1, the current storage element L11 is connected in series between the one-way semiconductor element D12 and the switch K7 to provide current limiting function; the branch composed by the switch K11 and one-way semiconductor element D16 provides current freewheeling function; the switch K7, current storage element L11, one-way semiconductor element D15, switch K10, and charge storage element C1 constitute the polarity inversion loop for charge storage element C1; Figure 26 shows a wave pattern of the current Iₘₐᵢₙ in the main loop, voltage V_{C1} across C1, and current I_{L2} in the polarity inversion circuit in the heating circuit shown in Figure 25. For the convenience of understanding, Figure 27 and Figure 28 provide equivalent circuit diagrams in the back-charge process. Hereunder an operating mode of the heating circuit shown in Figure 25 will be introduced, with reference to Figure 26:
a) The switching control module 100 controls the switch K6 to switch on, and thus the battery E discharges in forward direction (as indicated by the time period t1 shown in Figure 26);
b) At the end of the discharge process in forward direction, the switching control module 100 controls the switch K6 to switch off, and controls the switch K7 to switch on; thus, the charge storage element C1 charges the battery E in reverse direction through the switch K7, current storage element L11, and one-way semiconductor element D12 (as indicated by the time period t2 shown in Figure 26); in the process of reversed charging of battery E, the switch K7 can be controlled to switch on and switch off time after time, to reduce the current flowing to the battery E, as indicated by the time period t2 shown in Figure 26; in addition, the switch K11 is controlled to switch on in the reversed charging process, or the switch K11 is controlled to switch on after the switch K7 switches off when there is current flowing to the battery, so that the one-way semiconductor element D16 achieves current freewheeling function.
c) When the voltage across the charge storage element C1 reaches to the first preset value (higher than the voltage of the battery), the switching control module 100 controls the switch K7 to switch off, and controls the switch K11 to switch on, so as to achieve the current freewheeling function; when the current flowing through the current storage element C1 is zero, the switch K11 is controlled to switch off, and the switch K7 and K10 are controlled to switch on, and thus the charge storage element C1 discharges through the switch K7, current storage element L11, one-way semiconductor element D15, and switch K10, and attain the purpose of voltage polarity inversion of the charge storage element C1; then, the switching control module 100 controls the switch K7 and K10 to switch off, as indicated by the time period t3 shown in Figure 26;
d) Repeat step a) to step c); the battery E is heated up continuously while it discharges and is charged, till the battery E meets the heating stop condition.

Hereunder another optional operating mode of the heating circuit shown in Figure 25 will be introduced, with reference to Figure 29:
a) The switching control module 100 controls the switch K6 to switch on, and thus the battery E discharges in forward direction (as indicated by the time period t1 shown in Figure 26);
b) At the end of the discharge process in forward direction, the switching control module 100 controls the switch K6 to switch off, and controls the switch K7 to switch on and switch off time after time; the charge storage element C1 charges the battery E in reverse direction through the switch K7, current storage element L11, and one-way semiconductor element D12 (as indicated by the time periods t0∼t8 shown in Figure 29); in addition, the switch K4 is controlled to switch on in the reversed charging process, or the switch K4 is controlled to switch on after the switch K7 switches off when there is current flowing to the battery, so that the one-way semiconductor element D16 achieves current freewheeling function. For example, at time t0, the switch K7 switches on, the charge storage element C1 charges the battery E through K7, L11, and D15, and stores energy in the current storage element L11 at the same time; when the current in the current storage element L11 rises to the first set value of current, as indicated by the time t1 shown in Figure 29, the switch K7 switches off, and the switch K11 switches on at the same time (K11 can be in ON state before K7 switches off, till the back-charge process completes), and thus the inductor sustains the current flowing through the switch K11 and one-way semiconductor element D16; when the current in the current storage element L11 drops to the second set value of current, as indicated by the time t2 shown in Figure 29, the switch K7 switches on again, and the next back-charge cycle starts.
c) When the voltage across the charge storage element C1 reaches to the second preset value (lower than or equal to the voltage of the battery, as shown Figure 29, where the second preset value is equal to the voltage of the battery), the switching control module 100 controls the switch K7 to switch off, and controls the switch K11 to switch on, to achieve current freewheeling function; when the current flowing through the current storage element L11 reaches to the second set value of current, the switch K11 is controlled to switch off, while the switch K7 and K10 are controlled to switch on; now, the equivalent circuit is shown in Figure 28, and the waveform is shown in the time period t8∼t12 in Figure 29; the circuit composed of one-way semiconductor element D15, switch K7, current storage element L11, one-way semiconductor element D12, and switch K10 transfers the energy in the charge storage element C1 back to the battery E, and then inverts the voltage polarity of the charge storage element C1. At time t8, the switch K7 and K10 switch on at the same time, the charge storage element Cl stores energy in the current storage element L11 through the switch K7, one-way semiconductor element D15, and switch K10; when the current in the current storage element L11 rises to the first set value of current, as indicated by the time t9 shown in Figure 29, the switch K10 switches off, the current storage element L11 sustains the current through the switch K7 and one-way semiconductor element D12; when the current flowing through the current storage element L11 drops to the second set value of current, as indicated by the time t10 shown in Figure 29, the switch K10 switches on again, and the next back-charge cycle starts, till the voltage of the capacitor reaches to a set value of voltage. When the current flowing through the current storage element L11 is zero, switch K7 and K10 switch on, so that the voltage polarity of the charge storage element C1 is inverted;
d) Repeat step a) to step c); the battery E is heated up continuously while it discharges and is charged, till the battery E meets the heating stop condition.

The heating circuit provided in the present invention can improve the charge/discharge performance of the battery; in addition, since the energy storage circuit is connected with the battery in series in the heating circuit, safety problem caused by overcurrent as short circuit related with failures of the switch unit can be avoided when the battery is heated due to the existence of the charge storage elements C1 connected in series, and therefore the battery can be protected effectively.

While some preferred embodiments of the present invention are described above with reference to the accompanying drawings, the present invention is not limited to the details in those embodiments. Those skilled in the art can make modifications and variations to the technical scheme of the present invention, without departing from the spirit of the present invention. However, all these modifications and variations shall be deemed as falling into the protected domain of the present invention.

In addition, it should be noted: the specific technical features described in above embodiments can be combined in any appropriate form, provided that there is no conflict. To avoid unnecessary repetition, the possible combinations are not described specifically in the present invention. Moreover, the different embodiments of the present invention can be combined freely as required, as long as the combinations don't deviate from the ideal and spirit of the present invention. However, such combinations shall also be deemed as falling into the scope disclosed in the present invention.

## Claims

1. A battery heating circuit, comprising a switch unit (1), a switching control module (100), a damping element R1, an energy storage circuit, and an energy limiting circuit, wherein, the energy storage circuit is connected with the battery, and comprises a current storage element L1 and a charge storage element C1; the damping element R1, the switch unit (1), the current storage element L1, and the charge storage element C1 are connected in series; the switching control module (100) is connected with the switch unit (1), and is configured to control ON/OFF of the switch unit (1), so that the energy can flow to and fro between the battery and the energy storage circuit when the switch unit (1) switches on; the energy limiting circuit is configured to limit the magnitude of current flowing from the energy storage circuit to the battery.

2. The heating circuit according to Claim 1, wherein, the switch unit (1) comprises a first one-way branch designed to enable energy flow from the battery to the energy storage circuit and a second one-way branch designed to enable energy flow from the energy storage circuit to the battery; the switching control module (100) is connected to either or both of the first one-way branch and second one-way branch, and is designed to control ON/OFF of the switch unit (1) by controlling ON/OFF of the connected branches.

3. The heating circuit according to claim 2, wherein, the energy limiting circuit comprises a current storage element L11, which is connected in series in the second one-way branch.

4. The heating circuit according to Claim 3, wherein, the switch unit (1) comprises a switch K6, a one-way semiconductor element D11, and a one-way semiconductor element D12, the switch K6 and the one-way semiconductor element D11 are connected with each other in series to constitute the first one-way branch; the one-way semiconductor element D12 constitutes the second one-way branch; the switching control module (100) is connected with the switch K6, and is designed to control ON/OFF of the first one-way branch by controlling ON/OFF of the switch K6.

5. The heating circuit according to Claim 4, wherein, the switch unit (1) further comprises a switch K7 in the second one-way branch, and the switch K7 is connected with the one-way semiconductor element D12 in series; the switching control module (100) is further connected with the switch K7, and is designed to control ON/OFF of the second one-way branch by controlling ON/OFF of the switch K7.

6. The heating circuit according to claim 5, wherein, the heating circuit further comprises an one-way semiconductor element D15, an one-way semiconductor element D16, a switch K10, and a switch K11; the negative electrode of the one-way semiconductor element D16 is connected between the switch K7 and the charge storage element L11, the positive electrode of the one-way semiconductor element D16 is connected to one end of the switch K11, and the other end of the switch K11 is connected to the negative electrode of the battery; the positive electrode of the one-way semiconductor element D15 is connected between the one-way semiconductor element D12 and the charge storage element L11, the negative electrode of the one-way semiconductor element D15 is connected to one end of the switch K10, and the other end of the switch K10 is connected to the negative electrode of the battery; the switching control module (100) is also connected with the switch K10 and the switch K11 respectively, to control ON/OFF of the switch K10 and the switch K11.

7. The heating circuit according to claim 6, wherein, the switching control module (100) is configured to:
control the switch K6 and the switch K7 to switch on, so that the energy can flow from the battery to the charge storage element C1 and flow from the charge storage element C1 back to the battery;
control the switch K7 to switch off and control the switch K11 to switch on when the voltage across the charge storage element C1 reaches to a first preset value which is higher than the voltage of the battery;
control the switch K11 to switch off when the current flowing through the current storage element L11 is zero, and control the switch K7 and switch K10 to switch on, so as to invert the voltage polarity of the charge storage element C1.

8. The heating circuit according to claim 6 or 7, wherein, the switching control module (100) is configured to:
control the switch K6 and switch K7 to switch on, so that the energy can flow from the battery to the charge storage element C1 and flows from the charge storage element C1 back to the battery;
control the switch K7 to switch off and control the switch K11 to switch on when the voltage across the charge storage element C1 reaches to a second preset value which is lower than or equal to the voltage of the battery;
control the switch K11 to switch off and control the switch K7 and the switch K10 to switch on when the current flowing through the current storage element L11 reaches to a second set value of current;
control the switch K10 to switch off when the current flowing through the current storage element L1 reaches to a first set value of current, so that the energy in the current storage element L11 flows to the battery;
control the switch K7 and switch K10 to switch on when the current flowing through the current storage element L11 is zero, so as to invert the voltage polarity of the charge storage element C1.

9. The heating circuit according to one of the preceding claims, wherein, the heating circuit further comprises an energy superposition unit, which is connected with the energy storage circuit, and is designed to superpose the energy in the energy storage circuit with the energy in the battery after the switching control module (100) controlling the switch unit (1) to switch on and then to switch off; the energy superposition unit comprises a polarity inversion unit (102), which is connected with the energy storage circuit, and is designed to invert the voltage polarity of the charge storage element C1 after the switch unit (1) switches on and then switches off.

10. The heating circuit according to one of the preceding claims, wherein, the heating circuit further comprises an energy transfer unit, which is connected with the energy storage circuit, and is designed to transfer the energy in the energy storage circuit to an energy storage element after the switch unit (1) switches on and then switches off; the energy transfer unit comprises an electricity recharge unit (103), which is connected with the energy storage circuit, and is designed to transfer the energy in the energy storage circuit to the energy storage element after the switch unit (1) switches on and then switches off.

11. The heating circuit according to one of the preceding claims, wherein, the heating circuit further comprises an energy superposition and transfer unit connected with the energy storage circuit; the energy superposition and transfer unit is designed to transfer the energy in the energy storage circuit to an energy storage element after the switch unit (1) switches on and then switches off, and then superpose the remaining energy in the energy storage circuit with the energy in the battery.

12. The heating circuit according to claim 11, wherein, the energy superposition and transfer unit comprises an energy superposition unit and an energy transfer unit; the energy transfer unit is connected with the energy storage circuit, and is designed to transfer the energy in the energy storage circuit to an energy storage element after the switch unit (1) switches on and then switches off; the energy superposition unit is connected with the energy storage circuit, and is designed to superpose the remaining energy in the energy storage circuit with the energy in the battery after the energy transfer unit performs energy transfer; the energy transfer unit comprises an electricity recharge unit (103), which is connected with the energy storage circuit, and is designed to transfer the energy in the energy storage circuit to the energy storage element after the switch unit (1) switches on and then switches off; the energy superposition unit comprises a polarity inversion unit (102), which is connected with the energy storage circuit, and is designed to invert the voltage polarity of the charge storage element C1 after the electricity recharge unit (103) performs energy transfer.

13. The heating circuit according to claim 11 or 12, wherein, the energy superposition and transfer unit comprises a DC-DC module (4), which is connected with the charge storage element C1 and the battery respectively; the switching control module (100) is also connected with the DC-DC module (4), and is designed to control the operation of the DC-DC module (4) to transfer the energy in the charge storage element C1 to the energy storage element, and then superpose the remaining energy in the charge storage element C1 with the energy in the battery.

14. The heating circuit according to one of the claims 9 to 13, wherein, the polarity inversion unit (102) comprises a single pole double throw switch J1 and a single pole double throw switch J2 located on the two ends of the charge storage element C1 respectively; the input wires of the single pole double throw switch J1 are connected in the energy storage circuit, the first output wire of the single pole double throw switch J1 is connected with the first pole plate of the charge storage element C1, and the second output wire of the single pole double throw switch J1 is connected with the second pole plate of the charge storage element C1; the input wires of the single pole double throw switch J2 are connected in the energy storage circuit, the first output wire of the single pole double throw switch J2 is connected with the second pole plate of the charge storage element C1, and the second output wire of the single pole double throw switch J2 is connected with the first pole plate of the charge storage element C1; the switching control module (100) is also connected with the single pole double throw switch J1 and single pole double throw switch J2 respectively, and is designed to invert the voltage polarity of the charge storage element C1 by altering the connection relationships between the respective input wires and output wires of the single pole double throw switch J1 and the single pole double throw switch J2.

15. The heating circuit according to one of the claims 9 to 14, wherein, the polarity inversion unit (102) comprises a one-way semiconductor element D3, a current storage element L2, and a switch K9; the charge storage element C1, current storage element L2, and switch K9 are connected sequentially in series to form a loop; the one-way semiconductor element D3 is connected in series between the charge storage element C1 and the current storage element L2 or between the current storage element L2 and the switch K9; the switching control module (100) is also connected with the switch K9, and is designed to invert the voltage polarity of the charge storage element C1 by controlling the switch K9 to switch on.

16. The heating circuit according to one of the claims 9 to 15, wherein, the polarity inversion unit (102) comprises a first DC-DC module (2) and a charge storage element C2; the first DC-DC module (2) is connected with the charge storage element C1 and the charge storage element C2 respectively; the switching control module (100) is also connected with the first DC-DC module (2), and is designed to transfer the energy in the charge storage element C1 to the charge storage element C2 by controlling the operation of the first DC-DC module (2), and then transfer the energy in the charge storage element C2 back to the charge storage element C1, so as to invert the voltage polarity of the charge storage element C1.

17. The heating circuit according to one of the claims 10 to 16, wherein, the electricity recharge unit (103) comprises a second DC-DC module (3), which is connected with the charge storage element C1 and the battery respectively; the switching control module (100) is also connected with the second DC-DC module (3), and is designed to transfer the energy in the charge storage element C1 to the battery by controlling the operation of the second DC-DC module (3).

18. The heating circuit according to one of the preceding claims, wherein, the heating circuit further comprises an energy consumption unit, which is connected with the charge storage element C1 and designed to consume the energy in the charge storage element C1 after the switch unit (1) switches on and then switches off; the energy consumption unit comprises a voltage control unit (101), which is designed to convert the voltage across the charge storage element C1 to a predetermined value of voltage after the switch unit (1) switches on and then switches off.

19. The heating circuit according to one of the claims 9 to 18, wherein, the heating circuit further comprises an energy consumption unit, which is connected with the charge storage element C1, and is designed to consume the energy in the charge storage element C1 after the switch unit (1) switches on and then switches off and before the energy superposition unit performs energy superposition; the energy consumption unit comprises a voltage control unit (101), which is connected with the charge storage element C1, and is designed to convert the voltage across the charge storage element C1 to a predetermined value of voltage after the switch unit (1) switches on and then switches off and before the energy superposition unit performs energy superposition.

20. The heating circuit according to one of the claims 10 to 19, wherein, the heating circuit further comprises an energy consumption unit, which is connected with the charge storage element C1, and is designed to consume the energy in the charge storage element C1 after the switch unit (1) switches on and then switches off and before the energy transfer unit performs energy transfer, or consume the energy in the charge storage element C1 after the energy transfer unit performs energy transfer; the energy consumption unit comprises a voltage control unit (101), which is connected with the charge storage element C1, and is designed to convert the voltage across the charge storage element C1 to a predetermined value of voltage after the switch unit (1) switches on and then switches off and before the energy transfer unit performs energy transfer, or convert the voltage across the charge storage element C1 to a predetermined value of voltage after the energy transfer unit performs energy transfer.

21. The heating circuit according to one of the claims 11 to 20,wherein, the heating circuit further comprises an energy consumption unit, which is connected with the charge storage element C1, and is designed to consume the energy in the charge storage element C1 after the switch unit (1) switches on and then switches off and before the energy superposition and transfer unit performs energy transfer, or consume the energy in the charge storage element after the energy superposition and transfer unit performs energy transfer and before the energy superposition and transfer unit performs energy superposition; the energy consumption unit comprises a voltage control unit (101), which is connected with the charge storage element C1, and is designed to convert the voltage across the charge storage element C1 to a predetermined value of voltage after the switch unit (1) switches on and then switches off and before the energy superposition and transfer unit performs energy transfer, or convert the voltage across the charge storage element C1 to a predetermined value of voltage after the energy superposition and transfer unit performs energy transfer and before the energy superposition and transfer unit performs energy superposition.

22. The heating circuit according to any of Claims 18 to 21, wherein, the voltage control unit (101) comprises a damping element R5 and a switch K8, the damping element R5 and the switch K8 are connected with each other in series, and then connected in parallel across the charge storage element C1; the switching control module (100) is further connected with the switch K8, and is designed to control the switch K8 to switch on after the control switch unit (1) switches on and then switches off.

23. The heating circuit according to any of Claims 9 to 22, wherein, the switching control module (100) is designed to control the switch unit (1) to switch off when or after the current flow through the switch unit (1) reaches to zero after the switch unit (1) switches on.

24. The heating circuit according to one of the preceding claims, wherein, the damping element R1 is the parasitic resistance in the battery, and the current storage element L1 is the parasitic inductance in the battery.
